# EUROPÄISCHE PATENTSCHRIFT

(11) **EP 2 126 154 B1**
(45) Veröffentlichungstag und Bekanntmachung des Hinweises auf die Patenterteilung: **22.06.2011**
(21) Anmeldenummer: 08706890.4
(22) Anmeldetag: 14.02.2008
(51) Int. Cl.: C23C 10/48, C23C 10/52, C23C 16/08, C23C 28/00, C23C 30/00, F01D 5/28

(54) **BESCHICHTUNG FÜR GASTURBINENBAUTEILE SOWIE VERFAHREN ZUR BEREITSTELLUNG EINER BESCHICHTUNG**
COATING FOR GAS TURBINE COMPONENTS AND METHOD FOR PROVIDING A COATING
REVÊTEMENT POUR COMPOSANT DE TURBINE À GAZ ET PROCÉDÉ DE PRÉPARATION D'UN REVÊTEMENT

(30) Priorität: 20.02.2007 DE 102007008278
(43) Veröffentlichungstag der Anmeldung: 02.12.2009
(73) Patentinhaber: MTU Aero Engines GmbH, 80995 München (DE)
(72) Erfinder: PILLHÖFER, Horst, 85244 Röhrmoos (DE); WALTER, Heinrich, 86316 Friedberg (DE); NIEDERMEIER, Markus, 80469 München (DE); KOHLSCHEEN, Jörn, 28357 Bremen (DE)
(86) Internationale Anmeldenummer: PCT/DE2008/000280
(87) Internationale Veröffentlichungsnummer: WO 2008/101474

(56) Entgegenhaltungen:
- EP-A- 1 493 844
- EP-A- 1 544 323
- TAMARIN .Y: "Protective Coatings for Turbine Blades" 2002, ASM INTERNATIONAL , USA , XP002482643 das ganze Dokument
- KUZNETSOV ET AL: "Gradient Complex Protective Coatings for Sinlg Crystal Turbine Blades of High Heat Turbine Engines" MATERIAL SCIENCE AND HEAT TREATMENT, Bd. 49, Nr. 5, 2007, Seiten 253-259, XP002482641 Russia

## Beschreibung

Die Erfindung betrifft eine Beschichtung nach dem Oberbegriff des Anspruchs 1. Des Weiteren betrifft die Erfindung ein Verfahren zur Bereitstellung einer Beschichtung nach dem Oberbegriff des Anspruchs 6.

Die wichtigsten, heutzutage für Gasturbinenbauteile verwendeten Werkstoffe sind Titanbasislegierungen, Superlegierungen und hochfeste Stähle. Unter Superlegierungen versteht man Nickelbasislegierungen und Kobaltbasislegierungen. Die hochfesten Stähle werden für Wellenteile, Getriebeteile, Verdichtergehäuse und Turbinengehäuse einer Gasturbine verwendet. Titanbasislegierungen sind typische Werkstoffe für Verdichterteile. Superlegierungen sind für die heißen Teile einer Gasturbine und damit für Hochtemperaturanwendungen geeignet.

Bei der Verwendung in Gasturbinen sind Bauteile aus Superlegierungen Temperaturen von mehr als 1000°C, hohen Spannungen durch Fliehkräfte sowie hohen Temperaturwechselbelastungen ausgesetzt. Für Gasturbinenbauteile verwendete Superlegierungen sind typischerweise für eine gute Kombination aus Temperaturfestigkeit, Kriechfestigkeit und Dehnwechselbelastbarkeit ausgelegt. Dies erfolgt durch die Wahl geeigneter Legierungselemente und durch den Einsatz von gerichtet erstarrten bzw. einkristallin erstarrten Werkstoffen.

Allerdings führen Maßnahmen, die der Festigkeitssteigerung eines Werkstoffs dienen, typischerweise zu einer höheren Empfindlichkeit von Oberflächen und Randschichten gegenüber Heizgasoxidation und Heizgaskorrosion. Daher werden Gasturbinenbauteile mit Schutzschichten versehen, um die Bauteile vor Heizgasoxidation und Heizgaskorrosion zu schützen.

Zum Aufbringen von Schutzschichten auf Gasturbinenbauteile sind aus der Praxis als Beschichtungsverfahren in erster Linie Diffusionsbeschichtungsverfahren sowie Auflagebeschichtungsverfahren zum Beispiel aus EP 1493844 A1 bekannt. Diffusionsbeschichtungen beruhen auf einer Interdiffusion von abgeschiedenen Elementen des Beschichtungswerkstoffs mit Elementen der Superlegierung des zu beschichtenden Bauteils, wobei Diffusionsbeschichtungsverfahren in Hochaktivitätsdiffusionsbeschichtungsverfahren sowie Niedrigaktivitätsdiffusionsbeschichtungsverfahren untergliedert werden.

Bei Hochaktivitätsdiffusionsbeschichtungsverfahren findet eine hohe Einwärtsdiffusion des Beschichtungswerkstoffs in den Werkstoff des zu beschichtenden Bauteils statt. Bei Niedrigaktivitätsdiffusionsbeschichtungsverfahren erfolgt hingegen eine stärkere Auswärtsdiffusion von Elementen des Werkstoffs des zu beschichtenden Bauteils in den Beschichtungswerkstoff der abgeschiedenen Beschichtung. Auflagebeschichtungsverfahren beruhen weniger auf einer Interdiffusion, vielmehr ist die Schutzwirkung der Beschichtung eine inhärente Eigenschaft des abgeschiedenen Materials oder der abgeschiedenen Materialpartikel.

Aus der Praxis bekannte Beschichtungsverfahren verfügen lediglich über eine geringe Abscheideleistung, des Weiteren bereitet die Beschichtung von innenliegenden Oberflächen, wie z.B. von Innengeometrien hohler Bauteile, mit den bislang bekannten Beschichtungsverfahren Schwierigkeiten. Bislang bekannte Beschichtungen verfügen über eine hohe Rissempfindlichkeit an außenliegenden Zonen, wodurch die Lebensdauer bekannter Beschichtungen beschränkt wird. Es besteht daher ein Bedarf an neuen Beschichtungen mit höherer Lebensdauer, an einem Verfahren zur Herstellung solcher Beschichtungen mit hoher Abscheideleistung sowie an einer Vorrichtung zur Herstellung einer solchen Beschichtung.

Hiervon ausgehend liegt der vorliegenden Erfindung das Problem zu Grunde, eine neuartige Beschichtung sowie ein Verfahren zur Bereitstellung einer Beschichtung zu schaffen.

Dieses Problem wird durch eine Beschichtung gemäß Anspruch 1 gelöst. Erfindungsgemäß macht die Außenschicht 10 % bis 60 % der Gesamtbeschichtung aus, wobei die Außenschicht im wesentlichen aus einer β-NiAl-Phase mit einem Al-Anteil zwischen 23 und 35 Gew.-% gebildet ist, wobei die Innenschicht 90 % bis 40 % der Gesamtbeschichtung ausmacht, und wobei die Innenschicht im wesentlichen aus einer γ-NiAl-Phase mit einem Al-Anteil von 5 - 15 Gew.-% gebildet ist.

Die erfindungsgemäße Beschichtung verfügt über eine relativ geringe Rissempfindlichkeit sowie über eine gute Festigkeit bei HCF-Belastungen sowie LCF-Belastungen. Die erfindungsgemäße Beschichtung stellt einen effektiven Schutz von Gasturbinenbauteilen gegenüber Heißgasoxidation sowie Heißgaskorrosion bereit.

Vorzugsweise beträgt der Al-Anteil in der β-NiAl-Phase der Außenschicht zwischen 27 und 32 Gew.-%.

Nach einer Weiterbildung der Erfindung umfasst die β-NiAl-Phase der Außenschicht weiterhin Cr und/oder Si und/oder Pt und/oder Pd.

Das erfindungsgemäße Verfahren zur Bereitstellung einer Beschichtung ist in Anspruch 6 definiert. Erfindungsgemäß wird in einer Startphase des Beschichtungsverfahrens ein Druck zwischen 30 und 1400 hPa eingestellt, wobei in der Startphase aus mindestens einem angebotenen Halogen bzw. mindestens einer angebotenen Halogenverbindung und mindestens einem angebotenen Spendermetall, insbesondere aus einer angebotenen Spendermetalllegierung, zumindest Metallmonohalogenide gebildet werden, wobei in einer sich an die Startphase anschließenden Beschichtungsphase des Beschichtungsverfahrens ein Druck zwischen 1050 und 4000 hPa eingestellt wird, und wobei in der Beschichtungsphase zumindest die in der Startphase gebildeten Metallmonohalogenide auf ein zu beschichtendes Bauteil abschieden werden.

Das erfindungsgemäße Beschichtungsverfahren zeichnet sich durch eine hohe Abscheideleistung aus. Mit dem erfindungsgemäßen Beschichtungsverfahren können einerseits außenliegende Oberflächen sowie andererseits innenliegende Oberflächen von zu beschichtenden Bauteilen gleichermaßen gut beschichtet werden.

In der Vorrichtung zur Bereitstellung sind die zu beschichtenden Bauteile und die Donatoren im Reaktionsraum beabstandet voneinander in parallelen Ebenen angeordnet, derart, dass der Abstand zwischen den zu beschichtenden Bauteilen und den Donatoren zwischen 10 und 150 mm beträgt.

Die Vorrichtung ermöglicht eine effektive sowie wirtschaftliche Beschichtung von zu beschichtenden Bauteilen.

Bevorzugte Weiterbildungen der Erfindung ergeben sich aus den Unteransprüchen und der nachfolgenden Beschreibung. Ausführungsbeispiele der Erfindung werden, ohne hierauf beschränkt zu sein, an Hand der Zeichnung näher erläutert. Dabei zeigt:

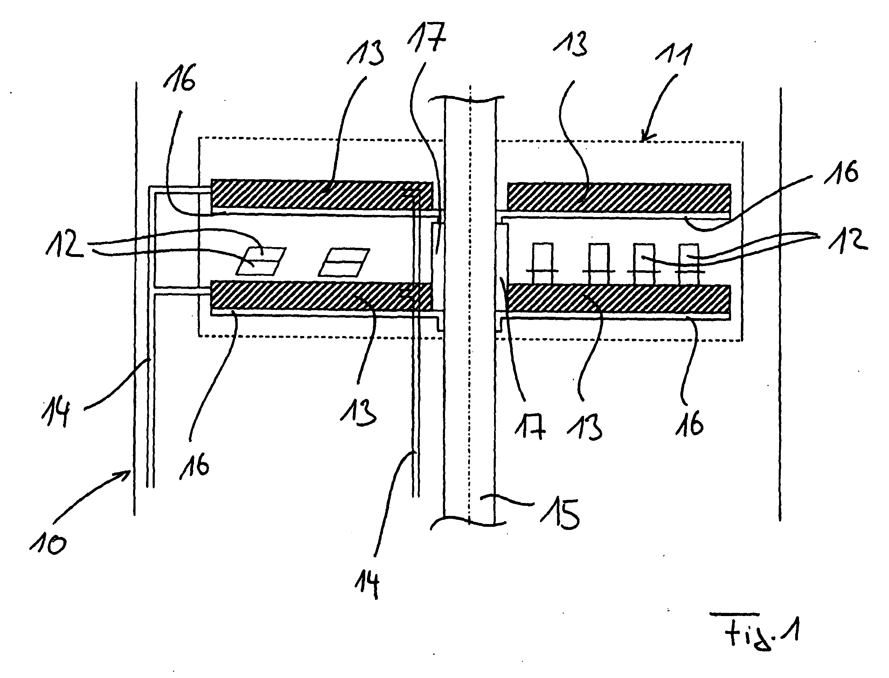

- Fig. 1: eine schematisierte Vorrichtung zur Bereitstellung einer Beschichtung.

Die hier vorliegende Erfindung betrifft eine neue Beschichtung für Gasturbinenbauteile, insbesondere für aus einer Superlegierung hergestellte Gasturbinenbauteile, zur Bereitstellung einer Schutzschicht gegenüber Heißgasoxidation sowie Heißgaskorrosion. Weiterhin betrifft die Erfindung ein Verfahren zur Herstellung einer solchen Beschichtung.

Die erfindungsgemäße Beschichtung verfügt über eine Außenschicht sowie eine Innenschicht. Die Außenschicht der erfindungsgemäßen Beschichtung macht zwischen 10% und 60% der Gesamtbeschichtung aus, wobei die Außenschicht im Wesentlichen aus einer β-NiAl-Phase mit einem Anteil an Aluminium (Al) zwischen 23 und 35 Gew.-% liegt. Vorzugsweise beträgt der Al-Anteil in der β-NiAl-Phase der Außenschicht zwischen 27 und 32 Gew.-%.

Die Innenschicht der Gesamtbeschichtung macht zwischen 90% bis 40% der Gesamtbeschichtung aus, wobei die Innenschicht im Wesentlichen aus einer γ-NiAl-Phase mit einem Anteil an Aluminium von max. 15 Gew.-% gebildet ist. Der Al-Anteil in der γ-NiAl-Phase der Innenschicht trägt insbesondere zwischen 5 und 15 Gew.-%.

Die gute Schutzeigenschaft gegenüber Heißgasoxidation sowie Heißgaskorrosion der erfindungsgemäßen Beschichtung wird durch den relativ hohen Aluminiumanteil in der Außenschicht aus der β-NiAl-Phase bereitgestellt. Die geringe Rissempfindlichkeit der erfindungsgemäßen Beschichtung wird durch die γ-NiAl-Phase der Innenschicht mit dem relativ geringen Anteil an Aluminium gewährleistet. Vorzugsweise ist die Innenschicht durch ein kubisches γ- bzw. γ'-Kristallgitter entsprechend der Kristallgitterstruktur des Grundwerkstoffs des zu beschichtenden Bauteils gekennzeichnet.

Eine weitere Steigerung der Oxidationsbeständigkeit sowie Korrosionsbeständigkeit der erfindungsgemäßen Beschichtung kann dadurch erreicht werden, dass die Außenschicht der erfindungsgemäßen Beschichtung Chrom und/oder Silizium und/oder Platin und/oder Palladium umfasst.

Dann, wenn die Außenschicht Chrom umfasst, beträgt der Chromanteil an der Außenschicht vorzugsweise zwischen 10 und 35 Gew.-%, insbesondere zwischen 20 und 30 Gew.-%. Dann, wenn die Außenschicht Silizium umfasst, beträgt der Anteil an Silizium zwischen 2 und 14 Gew.-%, insbesondere zwischen 4 und 9 Gew.-%. Dann, wenn die Außenschicht Platin und/oder Palladium umfasst, beträgt der Anteil an Platin und/oder Palladium zwischen 10 und 40 Gew.-%.

Das erfindungsgemäße Verfahren zur Bereitstellung der erfindungsgemäßen Beschichtung untergliedert sich zumindest in zwei Phasen, nämlich in eine Startphase sowie eine sich an die Startphase anschließende Beschichtungsphase.

In der Startphase des Beschichtungsverfahrens wird ein Druck zwischen 30 und 1400 hPa eingestellt, wobei in der Startphase aus mindestens einem angebotenen Halogen bzw. mindestens einer angebotenen Halogenverbindung und mindestens einem angebotenen Spendermetall, insbesondere aus einer angebotenen Spendermetalllegierung, zumindest Metallmonohalogenide gebildet werden.

Als Halogene werden vorzugsweise Chlor (Cl) oder Fluor (F) bzw. als Halogenverbindungen vorzugsweise Wasserstoffchlorid (HCl) oder Wasserstofffluorid (HF) bereitgehalten. Aus den Halogenen bzw. Halogenverbindungen und dem Spendermaterial werden Metallmonohalogenide gebildet.

In der Startphase des Beschichtungsverfahrens kommen in der Gasphase nach folgender Gleichung

MeₓHal_{y} + zMe ↔ MeHal ; x,z=1-2 und y=2-3

sowohl Halogenverbindungen MeₓHal_{y} als auch Metallmonohalegonide MeHal vor. Daher wird in der Startphase ein relativ geringer Druck zwischen 20 und 1400 hPa eingestellt, um in der Gasphase einen höheren Anteil an Metallmonohalegoniden bereitzustellen.

An die Startphase des Beschichtungsverfahrens schließt sich die Beschichtungsphase an, in der ein relativ hoher Druck zwischen 1050 und 4000 hPa eingestellt wird. In der Beschichtungsphase werden die in der Startphase bebildeten Metallmonohalegonide auf die Oberfläche des zu beschichtenden Bauteils abgeschieden, wobei hierbei die Metallmonohalegonide in einer sogenannten Zersetzungsreaktion oder Disproportionsreaktion mit dem Grundwerkstoff des zu beschichtenden Bauteils nach folgenden Gleichungen reagieren:

MeHal + Ni ↔ NiMe + MeₓHal_{y}; x=2-4 und y=1-3

oder

MeHal + Ni ↔ MeHal + Hal

In den obigen Gleichungen wurde angenommen, dass es sich beim Grundwerkstoff des zu beschichtenden Bauteils um Nickel Ni handelt.

Es liegt demnach im Sinne des erfindungsgemäßen Verfahrens, in einer Startphase Metallmonohalegonide bei relativ geringem Druck zwischen 30 und 1400 hPa bereitzustellen und die in der Startphase bereitgestellten Metallmonohalegonide in einer nachfolgenden Beschichtungsphase bei einem relativ hohen Druck zwischen 1050 und 4000 hPa auf die Oberfläche des zu beschichtenden Bauteils abzuscheiden.

Durch die Verwendung des relativ hohen Drucks zwischen 1050 und 4000 hPa in der Beschichtungsphase kann der relative Anteil an Metallhalegoniden in der Gasphase um die Bauteiloberfläche erhöht werden. Zum anderen führt der relativ hohe Druck in der Beschichtungsphase dazu, dass ein deutlich höherer Anteil an Metallabscheidung auf die zu beschichtende Oberfläche des Bauteils erfolgt. Ein weiterer Vorteil des relativ hohen Drucks in der Beschichtungsphase des erfindungsgemäßen Verfahrens liegt darin, dass sich eine erhöhte Streukraft einstellt, d. h. der Abstand des Spendermaterials kann zur Oberfläche des zu beschichtenden Bauteils bei gleicher Aktivität größer sein, wodurch eine gleichmäßigere Abscheidung bzw. Beschichtung des zu beschichtenden Bauteils realisiert werden kann. Durch die erhöhte Streukraft können des Weiteren innenliegende Oberflächen des zu beschichtenden Bauteils, insbesondere Innengeometrien von Hohlräumen, gut beschichtet werden. Ein weiterer Vorteil des relativ hohen Drucks in der Beschichtungsphase liegt im langandauernden Erhalt eines Metallhalegonidaktivators. Es ergibt sich demnach eine höhere Aktivatorverfügbarkeit sowie Aktivatorverweildauer, ohne dass zusätzliche Halogene bzw. Halogenverbindungen eingeleitet werden müssten. Dadurch kann mit höherer Abscheideleistung länger beschichtet werden.

Nach einer vorteilhaften Weiterbildung des erfindungsgemäßen Beschichtungsverfahrens schließt sich an die Beschichtungsphase eine Reaktionsphase mit einem Druck zwischen 500 und 1400 hPa an, wobei sich an diese Reaktionsphase eine weitere Beschichtungsphase mit einem Druck zwischen 1050 und 4000 hPa anschließt. Hierdurch kann die Abscheideleistung des erfindungsgemäßen Beschichtungsverfahrens nochmals gesteigert bzw. erhöht werden.

Durch die sich abwechselnden Phasen mit relativ hohen Drücken sowie relativ niedrigen Drücken wird eine Art thermochemische Pumpe zur Bildung der Metallmonohalegonide bereitgestellt, was letztendlich zu der guten Abscheideleistung des erfindungsgemäßen Beschichtungsverfahrens beiträgt.

Die Startphase erstreckt sich vorzugsweise über eine Zeitdauer zwischen 5 und 60 min, die sich an die Startphase anschließende Beschichtungsphase erstreckt sich vorzugsweise über eine Zeitdauer zwischen 10 und 120 min. Eine sich ggf. an die Beschichtungsphase anschließende Reaktionsphase erstreckt sich zwischen 5 und 60 min, eine sich ggf. hieran anschließende weitere Beschichtungsphase erstreckt sich insbesondere zwischen 10 und 120 min.

Das erfindungsgemäße Verfahren wird bei einer Prozesstemperatur zwischen 900° und 1150 °C, insbesondere bei einer Prozesstemperatur zwischen 940° und 1080 °C durchgeführt.

Dabei ist die Temperatur in der oder jeder Beschichtungsphase vorzugsweise zwischen 10° und 60° höher als die Temperatur der jeweils vorausgehenden Phase, also der Startphase bzw. der Reaktionsphase. Hierdurch können definierte Diffusionsprofile in Abhängigkeit der unterschiedlichen Metallabscheideaktivität in den verschiedenen Prozessphasen erzeugt werden.

Das Spendermetall wird vorzugsweise mit einer Partikelgröße zwischen 2 und 20 mm bereitgehalten, wobei das Halogen bzw. die Halogenverbindung direkt auf das Spendermaterial geleitet wird. Dabei umströmt vorzugsweise das Halogen bzw. die Halogenverbindung das Spendermaterial mit einer Strömungsgeschwindigkeit zwischen 0,1 1 und 10 cm pro Sekunde.

Auf die obige Art und Weise wird insbesondere Aluminium auf das zu beschichtende Bauteil abgeschieden.

Das Zulegieren der Elemente Chrom, Silizium, Platin bzw. Palladium erfolgt vorzugsweise durch eine Vorlegierung der Außenschicht mit einem thermischen, thermochemischen oder physikalischen Verfahren oder durch nachträgliches Eindiffundieren, wobei der Vorlegierung der Vorzug gegeben wird.

Auch ein Überalitieren einer Auflageschicht aus Partikeln der Elemente Chrom, Silizium, Platin bzw. Palladium oder Partikel aus einer Legierung mit diesen Elementen kann zu der erfindungsgemäßen Beschichtung führen.

Das erfindungsgemäße Verfahren zur Bereitstellung der erfindungsgemäßen Beschichtung wird in einer speziellen Vorrichtung durchgeführt, die eine wirtschaftliche Beschichtung zu beschichtender Bauteile ermöglicht. Fig. 1 zeigt eine solche Beschichtungsvorrichtung 10 stark schematisiert.

So umfasst die Beschichtungsvorrichtung 10 einen Reaktionsraum 11 zur Aufnahme zu beschichtender Bauteile 12 sowie zur Aufnahme von Donatoren 13 aus mindestens einem Spendermetall, insbesondere einer Spendermetalllegierung. Dabei sind die Donatoren 13 gemäß Fig. 1 in voneinander beabstandeten, parallel zueinander verlaufenden Ebenen angeordnet, wobei zwischen jeweils zwei benachbarten Ebenen aus Donatoren 13 zu beschichtende Bauteile 12 positioniert sind. Im Ausfiihrungsbeispiel der Fig. 1 sind lediglich zwei Ebenen aus Donatoren 13 dargestellt. Es können bis zu zehn Ebenen von Donatoren 13 übereinander im Reaktionsraum 11 positioniert sein.

Wie bereits ausgeführt, sind die zu beschichtenden Bauteile 12 zwischen jeweils zwei Ebenen aus Donatoren 13 angeordnet und zwar derart, dass der Abstand zwischen den zu beschichtenden Bauteilen 12 und den Donatoren 13 zwischen 10 und 150 mm, vorzugsweise zwischen 20 und 150 mm, beträgt.

Der Reaktionsraum ist vorzugsweise rotationssymmetrisch mit einem Durchmesser zwischen 200 und 1500 mm und einer Höhe von bis zu 1500 mm ausgebildet, wobei die Raumdichte der Donatoren 13 bezogen auf das Gesamtvolumen des Reaktionsraums 11 zwischen 2 % und 5 % beträgt.

Halogene bzw. Halogenverbindungen sind über Zuleitungen 14 in Richtung auf die Donatoren 13 förderbar, nämlich derart, dass die Halogene bzw. Halogenverbindungen direkt auf die Donatoren 13, nämlich feste Partikel des oder jedes Spendermetalls, geleitet werden. Dabei können, wie Fig. 1 zeigt, die Zuleitungen 14 einerseits von radial außen sowie andererseits von radial innen in den Reaktionsraum 11 eingeführt werden.

Die Beschichtungsvorrichtung 10 verfügt über ein Zentrierrohr 15, an welchem mehrere Querträger 16 angreifen. Die Querträger 16 dienen der Aufnahme der Donatoren 13, wobei übereinander angeordnete Querträger 16 über Distanzstücke 17 voneinander beabstandet sind.

Die Querträger 16 sind vorzugsweise in Umfangsrichtung gesehen segmentiert, und zwar mit einer Winkelteilung zwischen 22,5 ° und 60 °. In Umfangsrichtung gesehen ist demnach jeder Querträger 16 in sechs bis sechzehn Segmente unterteilt, wobei jedes Segment der Aufnahme von Donatoren 13 dient.

Die Vorrichtung ist modular aufgebaut und gegenüber Temperatureinwirkung und Legierungseinwirkung dehnungstolerant.

Wie bereits ausgeführt, werden die Halogene bzw. Halogenverbindungen nicht offen in den Reaktionsraum 11 eingeleitet, sondern über Zuleitungen 14 direkt auf die Donatoren 13 geleitet. Die Donatoren können fest geschlossen oder in offenzelliger Bauweise, mit einem Öffnungsanteil zwischen 5 % und 80 % ausgeführt sein. Vorzugsweise sind, wie bereits ausgeführt, die Donatoren 13 je Ebene mit einer definierten Winkelteilung segmentiert. Es ist auch möglich, je Donatorebene mehrere ringförmige Donatorsegmente konzentrisch zueinander anzuordnen.

## Patentansprüche

1. Beschichtung für aus einer Superlegierung hergestellte Gashubinenbauteile, wobei dieselbe eine auf das Bauteil aufgebrachte Innenschicht und eine auf die Innenschicht aufgebrachte Außenschicht aufweist, **gekennzeichnet durch**:
a) eine Außenschicht, die 10 % bis 60 % der Gesamtbeschichtung ausmacht, bestehend aus einer β-NiAl-Phase mit einem Al-Anteil zwischen 23 und 35 Gew.%, wahlweise noch bis zu 35 Gew.-% Cr, bis zu 14 Gew.-% Si, bis zu 40 Gew.-% Pt und/oder Pd und Rest Ni sowie Verunreinigungen, und
b) eine Innenschicht die 90 % bis 40 % der Gesamtbeschichtung ausmacht, bestehend aus einer γ-NiAl-Phase mit einem Al-Anteil zwischen 5 und 15 Gew.%, Rest Ni sowie Verunreinigungen.

2. Beschichtung nach Anspruch 1,
**dadurch gekennzeichnet,**
**dass** der Al-Anteil in der β-NiAl-Phase der Außenschicht zwischen 27 und 32 Gew.-% beträgt.

3. Beschichtung nach Anspruch 1 oder 2,
**dadurch gekennzeichnet,**
**dass** die Außenschicht Cr in einem Anteil zwischen 10 und 35 Gew.-%, insbesondere zwischen 20 und 30 Gew.-%, umfasst.

4. Beschichtung nach einem der Ansprüche 1 bis 3,
**dadurch gekennzeichnet,**
**dass** die Außenschicht Si in einem Anteil zwischen 2 und 14 Gew.-%, insbesondere zwischen 4 und 9 Gew.-%, umfasst.

5. Beschichtung nach einem der Ansprüche 1 bis 4,
**dadurch gekennzeichnet,**
**dass** die Außenschicht Pt und/oder Pd in einem Anteil zwischen 10 und 40 Gew.-% umfasst.

6. Verfahren zur Bereitstellung einer Beschichtung nach einem der Ansprüche 1 bis 5, als Gasphasenbeschichtung, **gekennzeichnet durch** folgende Schritte:
a) in einer Startphase des Beschichtungsverfahrens wird ein Druck zwischen 30 und 1400 hPa eingestellt, wobei in der Startphase aus mindestens einem angebotenen Halogen bzw. aus mindestens einer angebotenen Halogenverbindung und mindestens einem angebotenen Spendermetall, insbesondere aus einer angebotenen Spendermetalllegierung, zumindest Metallmonohalogenide gebildet werden;
b) in einer sich an die Startphase anschließenden Beschichtungsphase wird ein Druck zwischen 1050 und 4000 hPa eingestellt, wobei in der Beschichtungsphase die in der Startphase gebildeten Metallmonohalogenide auf ein zu beschichtendes Bauteil abschieden werden.

7. Verfahren nach Anspruch 6,
**dadurch gekennzeichnet,**
**dass** die Startphase gemäß Schritt a) für eine Zeitdauer zwischen 5 und 60 min und die Beschichtungsphase gemäß Schritt b) für eine Zeitdauer zwischen 10 und 120 min durchgeführt wird.

8. Verfahren nach Anspruch 6 oder 7,
**dadurch gekennzeichnet,**
**dass** in der Startphase als Halogenverbindung Wasserstoffchlorid und/oder Wasserstofffluorid auf das Spendermetall geleitet wird.

9. Verfahren nach Anspruch 8,
**dadurch gekennzeichnet,**
**dass** das Spendermetall mit einer Partikelgröße zwischen 2 und 20 mm bereithalten wird, und dass das Halogen bzw. die Halogenverbindung direkt auf das Spendermetall derart geleitet wird, dass das Halogen bzw. die Halogenverbindung das Spendermetall mit einer Strömungsgeschwindigkeit zwischen 0,1 bis 10 cm/sec umströmt

10. Verfahren nach einem der Ansprüche 6 bis 9,
**dadurch gekennzeichnet,**
**dass** in einer sich an die Beschichtungsphase gemäß Schritt b) anschließenden Reaktionsphase ein Druck zwischen 500 und 1400 hPa eingestellt wird, wobei die Reaktionsphase für eine Zeitdauer zwischen 5 und 60 min durchgeführt wird.

11. Verfahren nach Anspruch 10,
**dadurch gekennzeichnet,**
**dass** in einer sich an die Reaktionsphase anschließenden weiteren Beschichtungsphase ein Druck zwischen 1050 und 4000 hPa eingestellt wird, wobei die weitere Beschichtungsphase für eine Zeitdauer zwischen 10 und 120 min, durchgeführt wird.

12. Verfahren nach einem der Ansprüche 6 bis 11,
**dadurch gekennzeichnet,**
**dass** dasselbe bei einer Prozesstemperatur zwischen 900 und 1150 °C, insbesondere zwischen 940 und 1080 °C, durchgeführt wird,

13. Verfahren nach Anspruch 12,
**dadurch gekennzeichnet,**
**dass** die Temperatur der oder jeder Beschichtungsphase zwischen 10 und 60 °C höher ist als die Temperatur der jeweils vorausgehenden Startphase bzw. Reaktionsphase.

## Claims

1. A coating for gas turbine components produced from a superalloy, wherein the same has an inner layer applied to the component and an outer layer applied to the inner layer, **characterised by**:
a) an outer layer which constitutes 10% to 60% of the total coating, consisting of a ß-NiAl-phase with an Al proportion between 23 and 35% by weight, selectively additionally up to 35% by weight Cr, up to 14% by weight Si, up to 40% by weight Pt and/or Pd, and the remainder Ni and also impurities, and
b) an inner layer which constitutes 90% to 40% of the total coating, consisting of a γ-NiAl-phase with an Al proportion between 5 and 15% by weight, and the remainder Ni and also impurities.

2. A coating according to claim 1,
**characterised in that**
the Al proportion in the ß-NiAl-phase of the outer layer amounts to between 27 and 32% by weight.

3. A coating according to claim 1 or 2,
**characterised in that**
the outer layer contains Cr in a proportion between 10 and 35% by weight, in particular between 20 and 30% by weight.

4. A coating according to one of claims 1 to 3,
**characterised in that**
the outer layer contains Si in a proportion between 2 and 14% by weight, in particular between 4 and 9% by weight.

5. A coating according to one of claims 1 to 4,
**characterised in that**
the outer layer contains Pt and/or Pd in a proportion between 10 and 40% by weight.

6. Method for providing a coating according to one of claims 1 to 5, as a gas-phase coating, **characterised by** the following steps:
a) in a starting phase of the coating method a pressure of between 30 and 1400 hPa is set, wherein in the starting phase at least metal monohalides are formed from at least one halogen offered or from at least one halogen compound offered and at least one donor metal offered, in particular from a donor-metal alloy offered;
b) in a coating phase following on from the starting phase a pressure of between 1050 and 4000 hPa is set, wherein in the coating phase the metal monohalides formed in the starting phase are deposited onto a component that is to be coated.

7. Method according to claim 6,
**characterised in that**
the starting phase according to step a) is carried out for a period between 5 and 60 min, and the coating phase according to step b) is carried out for a period between 10 and 120 min.

8. Method according to claim 6 or 7,
**characterised in that**
in the starting phase, hydrogen chloride and/or hydrogen fluoride are/is conducted as the halogen compound onto the donor metal.

9. Method according to claim 8,
**characterised in that**
the donor metal is held in readiness with a particle size between 2 and 20 mm, and **in that** the halogen or the halogen compound is conducted directly onto the donor metal in such a way that the halogen or the halogen compound flows around the donor metal with a velocity of flow between 0.1 to 10 cm/sec.

10. Method according to one of claims 6 to 9,
**characterised in that**
in a reaction phase following on from the coating phase according to step b) a pressure of between 500 and 1400 hPa is set, wherein the reaction phase is carried out for a period between 5 and 60 min.

11. Method according to claim 10,
**characterised in that**
in a further coating phase following on from the reaction phase a pressure of between 1050 and 4000 hPa is set, wherein the further coating phase is carried out for a period between 10 and 120 min.

12. Method according to one of claims 6 to 11,
**characterised in that**
the same is carried out at a process temperature between 900 and 1150 °C, in particular between 940 and 1080 °C.

13. Method according to claim 12,
**characterised in that**
the temperature of the or each coating phase is between 10 and 60 °C higher than the temperature of the respectively preceding starting phase or reaction phase.

## Revendications

1. Revêtement pour composants de turbine à gaz produits en un super-alliage, celui-ci présentant une couche interne appliquée sur le composant et une couche externe appliquée sur la couche interne, **caractérisé par** :
a) une couche externe qui constitue de 10 % à 60 % du revêtement total, constituée d'une phase de β-NiAl comportant une proportion de Al entre 23 et 35 % en poids, éventuellement également jusqu'à 35 % en poids de Cr, jusqu'à 14 % en poids de Si, jusqu'à 40 % en poids de Pt et/ou de Pd et le reste étant constitué de Ni et d'impuretés, et
b) une couche interne qui constitue 90 % à 40 % du revêtement total, constituée d'une phase de γ-NiAl comportant une proportion de Al entre 5 et 15 % en poids, le reste étant constitué de Ni et d'impuretés.

2. Revêtement selon la revendication 1,
**caractérisé en ce**
**que** la proportion de Al dans la phase de β-NiAl de la couche externe se situe entre 27 et 32 % en poids.

3. Revêtement selon la revendication 1 ou 2,
**caractérisé en ce**
**que** la couche externe comprend du Cr en une proportion entre 10 et 35 % en poids, en particulier entre 20 et 30 % en poids.

4. Revêtement selon l'une des revendications 1 à 3,
**caractérisé en ce**
**que** la couche externe comprend du Si en une proportion de 2 à 14 % en poids, en particulier entre 4 et 9 % en poids.

5. Revêtement selon l'une des revendications 1 à 4,
**caractérisé en ce**
**que** la couche externe comprend du Pt et/ou du Pd en une proportion entre 10 et 40 % en poids.

6. Procédé de préparation d'un revêtement selon l'une des revendications 1 à 5, comme revêtement en phase gazeuse, **caractérisé par** les étapes suivantes :
a) dans une phase de départ du procédé de revêtement, une pression entre 30 et 1400 hPa est appliquée, au moins des monohalogénures métalliques étant formés dans la phase de départ à partir d'au moins un halogène proposé ou d'au moins un composé d'halogène proposé et au moins d'un métal donneur proposé, en particulier, d'un alliage de métal donneur proposé ;
b) dans une phase de revêtement consécutive à la phase de départ, une pression entre 1050 et 4000 hPa est appliquée, les monohalogénures métalliques formés dans la phase de départ étant déposés sur un composant à revêtir dans la phase de revêtement.

7. Procédé selon la revendication 6,
**caractérisé en ce**
**que** la phase de départ est réalisée selon l'étape a) pendant une durée entre 5 et 60 min et la phase de revêtement est réalisée selon l'étape b) pendant une durée entre 10 et 120 min.

8. Procédé selon la revendication 6 ou 7,
**caractérisé en ce**
**que** dans la phase de départ, on introduit comme composé d'halogène, du chlorure d'hydrogène et/ou du fluorure d'hydrogène.

9. Procédé selon la revendication 8,
**caractérisé en ce**
**que** le métal donneur est mis à disposition en une taille de particules entre 2 et 20 mm et en ce que l'halogène ou le composé d'halogène est acheminé directement sur le métal donneur de telle sorte que l'halogène ou le composé d'halogène entoure le métal donneur à une vitesse d'écoulement entre 0,1 et 10 cm/sec.

10. Procédé selon l'une des revendications 6 à 9,
**caractérisé en ce**
**que**, dans une phase réactionnelle consécutive à la phase de revêtement selon l'étape b), une pression entre 500 et 1400 hPa est appliquée, la phase réactionnelle étant réalisée pendant une durée entre 5 et 60 min.

11. Procédé selon la revendication 10,
**caractérisé en ce**
**que**, dans une autre phase de revêtement consécutive à la phase réactionnelle, une pression entre 1050 et 4000 hPa est appliquée, la phase de revêtement suivante étant réalisée pendant une durée entre 10 et 120 min.

12. Procédé selon l'une des revendications 6 à 11,
**caractérisé en ce**
**que** celle-ci est réalisée à une température de processus entre 900 et 1150° C, en particulier entre 940 et 1080° C.

13. Procédé selon la revendication 12,
**caractérisé en ce**
**que** la température de la ou de chaque phase de revêtement est entre 10 et 60° C supérieure à la température de la phase de départ ou de la phase réactionnelle précédente.
